# EUROPEAN PATENT SPECIFICATION

(11) **EP 3 224 640 B1**
(45) Date of publication and mention of the grant of the patent: **11.10.2023**
(21) Application number: 15794171.7
(22) Date of filing: 12.11.2015
(51) Int. Cl.: G01R 33/032

(54) **METHOD AND DEVICE FOR MEASURING STRONG MAGNETIC FIELDS ON A NANOMETER SCALE, E.G. ON A HARD DISK WRITE/READ HEAD**
VERFAHREN UND VORRICHTUNG ZUR MESSUNG NANOSKALIGER STARKER MAGNETFELDER WIE Z. B. AUF EINEM FESTPLATTENSCHREIB-/-LESEKOPF
PROCÉDÉ ET DISPOSITIF POUR MESURER DES CHAMPS MAGNÉTIQUES FORTS À L'ÉCHELLE NANOMÉTRIQUE, PAR EXEMPLE SUR UNE TÊTE D'ÉCRITURE/DE LECTURE DE DISQUE DUR

(30) Priority: 27.11.2014 DE 102014117428
(43) Date of publication of application: 04.10.2017
(73) Proprietor: Universität Stuttgart, Körperschaft des Öffentlichen Rechts, 70174 Stuttgart (DE)
(72) Inventor: REINHARD, Friedemann, 80939 München (DE); WRACHTRUP, Jörg, 70563 Stuttgart (DE)
(74) Representative: Qip Patentanwälte Dr. Kuehn & Partner mbB
(86) International application number: PCT/EP2015/076418
(87) International publication number: WO 2016/083140

(56) References cited:
- MAERTZ B ET AL: "Vector magnetic field microscopy using nitrogen vacancy centers in diamond", APPLIED PHYSICS LETTERS, AMERICAN INSTITUTE OF PHYSICS, 2 HUNTINGTON QUADRANGLE, MELVILLE, NY 11747, vol. 96, no. 9, 1 March 2010 (2010-03-01), pages 92504-92504, XP012132411, ISSN: 0003-6951, DOI: 10.1063/1.3337096
- Rolf Simon Schönfeld: "Optical readout of single spins for quantum computing and magnetic sensing", Dissertation, Fachbereich Physik der Freien Universität Berlin, 1 May 2011 (2011-05-01), pages 1-143, XP055143403, Retrieved from the Internet: URL:http://www.diss.fu-berlin.de/diss/serv lets/MCRFileNodeServlet/FUDISS_derivate_00 0000012199/Dissertation_Simon_Schoenfeld_P ublicVersion-2.pdf;jsessionid=89A943688E59 A31943E392CF5C20A935?hosts= [retrieved on 2014-09-30]
- FUCHS G D ET AL: "A quantum memory intrinsic to single nitrogen-vacancy centres in diamond", NATURE PHYSICS, NATURE PUBLISHING GROUP, LONDON, GB, vol. 7, no. 10, 1 October 2011 (2011-10-01), pages 790-794, XP002692843, ISSN: 1745-2473 [retrieved on 2011-06-26]
- G. D. FUCHS ET AL: "Gigahertz Dynamics of a Strongly Driven Single Quantum Spin", SCIENCE, vol. 326, no. 5959, 11 December 2009 (2009-12-11), pages 1520-1522, XP055245721, US ISSN: 0036-8075, DOI: 10.1126/science.1181193

## Description

### RELATED APPLICATIONS

The present application claims the priority of German Patent Application No. 10 2014 117 428.3, filed on November 27, 2014.

### FIELD OF THE INVENTION

The present invention relates to measuring magnetic fields on a nanometer scale wherein the magnetic fields may have magnetic flux densities in excess of 10 Millitesla (B > 10mT). Particularly, the present invention relates to a method and device which are suitable for measuring nanoscale strong magnetic fields e.g. on a hard disc write/read head.

### BACKGROUND OF THE INVENTION

Magnetic fields occur in various technical or biological applications. In order to be able to better understand properties of such applications and thereby enable e.g. better controlling of manufacturing, manipulating and/or operating the application, it may be important to precisely measure the magnetic fields with respect to their spatial extensions, their strength and/or their temporal behavior. Preferably, such measurements should be performed with high resolution, e.g. with a spatial resolution in a nanometer scale, a magnetic flux density resolution in a nanotesla scale and/or with a temporal resolution in a nanosecond scale.

As an example, it may be beneficial to obtain precise information about magnetic fields generated at a hard disc write/read head, sometimes also referred to as recorder head of a hard disc. Such heads are able to generating a strong magnetic field with e.g. more than 10mT, frequently more than 0,5T, in areas as small as some tens of nm² (square-nanometers) in order to write and/or read single magnetic bits on a magnetic hard disc. For example, in recent write/read heads, magnetic fields with flux densities of about 1T may be generated locally in a small area, the flux density sharply decreasing at the border of the area along a distance of a few tens of nanometers. Furthermore, such magnetic fields may be ramped up and down very rapidly, e.g. within a few nanoseconds.

Precisely measured information about spatial distribution and/or temporal behavior of generated magnetic fields may help for example in developing and designing new write/read heads. Furthermore, such information may be used for functionally testing write/read heads during production.

One prominent method for measuring locally delimited magnetic fields is magnetic force microscopy (MFM). Therein, the magnetic field is scanned with a magnetic nanostructure. An intensity of the magnetic field may be reconstructed from a force resulting on this nanostructure.

However, this method only enables spatial resolution of more than a few tens of nanometers. Furthermore, the strongly magnetic nanostructure may negatively alter the magnetic field to be measured. Furthermore, MFM is generally neither quantitative nor provides temporal resolution. Thus, information obtained by MFM may not be suitable for satisfyingly characterizing magnetic features of e.g. write/read heads of hard discs inter alia for developing new generations of such hard discs.

MAERTZ B ET AL: "Vector magnetic field microscopy using nitrogen vacancy centers in diamond", APPLIED PHYSICS LETTERS, AMERICAN INSTITUTE OF PHYSICS, 2 HUNTINGTON OUADRANGLE, MELVILLE, NY 11747, vol. 96, no. 9, 1 March 2010 (2010-03-01), pages 92504-92504, XP012132411, ISSN: 0003-6951, DOI: 10.1063/13337096 describes magnetic field measurements using NV centers in diamond.

R. Schönfeld: "Optical readout of single spins for quantum computing and magnetic sensing", Dissertation, Fachbereich Physik der Freien Universität Berlin, 1 May 2011 (2011-05-01), pages 1-143, XP055143403 describes optical readout of single spins for quantum computing and magnetic sensing.

FUCHS G D ET AL: "A quantum memory intrinsic to single nitrogen-vacancy centres in diamond", NATURE PHYSICS, NATURE PUBLISHING GROUP, LONDON, GB, vol. 7, no. 10, 1 October 2011 (2011-10-01), pages 790-794, XP002692843, ISSN: 1745-2473 describes a quantum memory intrinsic to single nitrogen-vacancy centres in diamond.

### SUMMARY OF THE INVENTION

Accordingly, there may be a need for a method and a device for measuring strong magnetic fields with high spatial resolution, magnetic flux density resolution and/or temporal resolution on a nanoscale.

Such need may be met with the subject matter according to the independent claims. Advantageous embodiments are defined in the dependent claims.

According to a first aspect, a method for measuring strong magnetic fields on a nanoscale is proposed. The method comprises *inter alia*:
(a) positioning a magnetic-field-dependent photoluminescent particle in close proximity to an area to by measured;
(b) performing manipulations for bringing the magnetic-field-dependent photoluminescent particle into a predetermined excitation level;
(c) ramping up a magnetic flux density at the area to be measured;
(d) irradiating the magnetic-field-dependent photoluminescent particle with electromagnetic microwave radiation in a specific frequency range;
(e) ramping down the magnetic flux density at the area to be measured; and
(f) detecting a quantum state of the magnetic-field-dependent photoluminescent particle.

In such method, steps (c) to (f) have to be performed in the indicated order. Steps (a) and (b) have to be performed before step (c) and may be performed in the indicated order or in a reverted order. Furthermore, in step (a), the magnetic-field-dependent photoluminescent particle and the area to by measured should be positioned suitably relative to each other which means that either the magnetic-field-dependent photoluminescent particle may be displaced relative to the area to be measured or vice versa.

According to a second aspect of the invention, a method of analyzing magnetic field generation properties of a hard disk write/read head is proposed wherein the method uses embodiments of the method according to the above first aspect of the invention.

According to a third aspect of the invention, a device for localized measuring of a strong magnetic field on a nanoscale is proposed. The device comprises a positioning element for positioning a particle relative to the magnetic field to be measured, a magnetic-field-dependent photoluminescent particle which is provided at the positioning element, a light source such as a laser for illuminating the magnetic-field-dependent photoluminescent particle, a microwave generator for irradiating the magnetic-field-dependent photoluminescent particle with electromagnetic microwave radiation, a photodetector for detecting photoluminescence from the magnetic-field-dependent photoluminescent particle and a controller. Therein, the controller is adapted to controlling the positioning device, the light source, the microwave generator and an external magnetic field generator for generating the strong magnetic field to be measured in a manner which is in accordance with the above first or second aspects of the invention. The external magnetic field generator may be e.g. a hard disk write/read head which is adapted to rapidly ramp up and down strong magnetic field on nanoscale areas.

Ideas to the above aspects and embodiments of the invention may be understood, inter alia, as being based on principles and cognition as described hereinafter. However, the scope of the invention shall only be defined by the claims.

As indicated in the introductory portion, conventional MFM may not provide for sufficient resolution in terms of local distribution, temporal behavior and/or flux density of strong magnetic fields e.g. on a modern hard disc write/read head.

The approach described herein proposes using beneficial properties of a magnetic-field-dependent photoluminescent particle (hereinafter referred to as "MFDP particle") as a nanoscale magnetic sensor. Generally, an MFDP particle is a particle which shows an intensity of photoluminescence which depends on a magnetic field in which the MFDP particle is located. The photoluminescence may be e.g. a fluorescence. Such MFDP particle may be a single localized atom, molecule, vacancy or a combination thereof. Accordingly, such MFDP particle may have very small dimensions of less than 10nm or preferably even less than 2nm.

For example, an NV center (Nitrogen Vacancy) in a diamond crystal has been found to beneficially serve as a MFDP particle. As will be described in more details below, such NV centers may comprise a single nitrogen atom implanted into a diamond crystal and having an adjacent vacancy in the crystal lattice wherein the NV center behaves similar to a single atom having predetermined excitation levels. The NV center is fixedly localized within the diamond lattice matrix and may therefore be precisely located e.g. by attaching a diamond tip comprising one or more NV centers on a tip of an atomic force microscope (AFM). Furthermore, the NV center shows various quantum states such as a spin triplet, i.e. three different spin states 0, -1 and 1. On the one hand, these spin states significantly differ with respect to their excitation properties, i.e. photoluminescent properties strongly differ depending on a current spin state of the NV center. On the other hand, energy levels of each of these spin states depend on a magnetic field at the location of the NV center, i.e. Zeeman shifts apply to the energy levels depending on a magnetic flux density. Transitions between spin states may be induced by resonant absorption of electromagnetic microwave radiation. Accordingly, an actual magnetic field measurement may be performed by electromagnetic microwave spectroscopy. The fact that photoluminescence of the NV center depends on an excitation level of the NV center, i.e. in which of the spin levels the NV center is currently set, may therefore be used to optically determine, i.e. by measuring photoluminescence of the NV center, whether resonant absorption of microwave radiation irradiated in a specific frequency range occurred. In other words, microwave absorption properties may be read out optically. From the microwave frequency which is resonantly absorbed, the magnetic flux density at the location of the NV center may then be deduced.

All these properties may be used for applying the NV center as a very sensitive sensor for magnetic fields. The NV center has very small dimensions of a few nanometers and may be positioned very precisely on a nanometer scale using principles as applied e.g. in an AFM. Furthermore, the magnetic field dependence of the Zeeman shifts of the triplet spin levels allows for extreme magnetic field sensitivity in an order of nanotesla. Additionally, the NV center reacts very quickly on changes in magnetic flux densities thereby in principle enabling high temporal resolution in an order of nanoseconds.

However, it has been observed that at magnetic flux densities exceeding 10mT, i.e. more than 100 Gauss, at the area to be measured, an unambiguous dependence of fluorescence may not be measured anymore owing to mixing of spin sublevels.

It is therefore proposed to separate, in terms of time, the spectroscopy including the resonant electromagnetic microwave absorption from the measurement of the quantum states of the MFDP particle which may be implemented for example as an optical measurement of photoluminescence of the NV center.

In other words, the method step (b) of performing manipulations for bringing the MFDP particle into a predetermined excitation level and the methods step (f) of detecting a quantum state of the MFDP particle are performed before and after, respectively, the method steps (c) and (e) of ramping up and down a magnetic field intensity which themselves are performed before and after, respectively, the actual magnetic field measurement in step (d). Accordingly, only the step of resonantly exciting spin states of the NV center by microwave irradiation is performed at high magnetic fields whereas the step of optically reading out photoluminescence properties of the NV center is performed at low or no magnetic field. Thereby, any measurement problems which would otherwise occur during optically reading out photoluminescence properties due to mixing of spin levels at high magnetic fields may be avoided.

According to an embodiment of the invention, in method step (b), the MFDP particle is brought into the predetermined excitation level using illumination with light using e.g. a laser. In other words, before starting the actual spectroscopy procedure, the MFDP particle, i.e. for example the NV center, shall be brought into a defined excitation state such as e.g. a ground state or another one of the triplet spin states. Thereby, the MFDP particle is prepared for subsequent spectroscopy. For this purpose, laser light may be irradiated. This laser light should have a frequency which enables optical pumping of the spin of the MFDP particle into its ground state in order to induced bringing the MFDP particle into its ground state. In case the MFDP particle is an NV center, irradiating laser light with a frequency of less than 637nm may be applied. For example, a laser emitting at 532nm may be used.

Predefinedly starting e.g. in an excitation ground state, the spectroscopy may then be started by irradiating the MFDP particle at specific microwave frequencies and detecting whether resonant microwave absorption occurred such that the MFDP particle changed to an excited state thereby changing its photoluminescence properties.

Alternatively, the MFDP particle may be first prepared into a ground state by illumination and may then be prepared into one of its excited triplet spin states by microwave absorption at no or low magnetic field. The MFDP being in such excited state, the magnetic field may then be ramped up and the actual spectroscopy process may be performed by applying electromagnetic microwave radiation and checking whether resonant stimulated emission occurs.

According to an embodiment of the invention, in step (f), the quantum state of the magnetic-field-dependent photoluminescent particle is detected by measuring an intensity of photoluminescence of the magnetic-field-dependent photoluminescent particle. Therein, it may be used that the photoluminescence of the MFDP particle may depend on the current quantum state of the particle such that this quantum state may be read out optically by measuring the photoluminescence. For example, the photoluminescence of an NV center generally depends on the quantum state currently taken by the NV center. As an alternative to optically reading out the quantum state of the MFDP particle, in principle this quantum state may also be detected by other means, such as for example electrically.

According to an embodiment of the invention, in method steps (c) and (e), the ramping up and down of the magnetic flux density is performed adiabatically. Adiabatically changing the magnetic flux density may avoid that the MFDP particle's spin states are perturbed during ramping up or down the magnetic field. Therein, "adiabatically" may mean that the ramping is performed slowly with respect to e.g. a zero field splitting of an NV center which is typically at about 3 GHz. For example, the ramping up and down of the magnetic field intensity may be performed in a time scale of more than 1ns, preferably more than 3ns, i.e. a field sweep to e.g. 1 T may be performed on a slower time scale than 3ns.

It may be noted that under specific circumstances, in method steps (c) and (e), the ramping up and down of the magnetic flux density may be performed non-adiabatically, i.e. much faster than stated above, preferably quasi-instantaneously. Therein, "quasi-instantaneously" may mean that the ramping is performed fast with respect to the smallest energy difference between the energy levels of an NV center occurring during the ramp. Such fast ramping may be accepted e.g. in circumstances where the magnetic field is almost perfectly aligned with the axis of the NV center. For example, the ramping up and down of the magnetic field intensity may be performed on a time scale of less than 1µs, preferably less than 10ns, more preferably less than 2ns, in a magnetic field that is aligned to the NV axis with a deviation of less than 10°.

According to an embodiment of the invention, the proposed method further comprises repositioning the magnetic-field-dependent photoluminescent particle along the area to by measured thereby scanning the area to be measured and repeating the method steps (b) to (f) at each position. In other words, magnetic field properties may be analyzed along a macroscopic surface by successively scanning the MFDP particle along the surface and performing method steps (b) to (f) at each of multiple positions of the surface. In such scenario, when the microwave frequency applied during spectroscopy is keep constant for all positions, a map of the measured surface indicating lines of same magnetic flux density, i.e. an "iso-flux-density-map", may be provided.

According to an embodiment of the invention, in the proposed method, step (d) of irradiating the MFDP particle with electromagnetic microwave radiation in a specific frequency range is performed after completely ramping up of a magnetic flux density. In other words, first, the magnetic field is ramped up to its maximum flux density and then the microwave absorption spectroscopy is performed. Accordingly, the magnetic field is measured at maximum flux density. In other words, for example when analyzing magnetic properties of a magnetic disc read/write head, the surface of the head may be mapped in a steady state at maximum magnetic field generation.

According to an alternative embodiment of the invention, in the proposed method, step (d) is performed during the ramping up of a magnetic field intensity. In other words, the magnetic field is not ramped up to its maximum flux density and only then the microwave absorption spectroscopy is performed. Instead, the magnetic field is ramped up only up to an intermediate flux density lower than the maximum flux density and then the microwave absorption spectroscopy is performed. Accordingly, the magnetic field may be spectroscopically measured at such intermediate flux densities. In such embodiment, steps (b) to (f) may be repeated several times and step (d) may be performed at different stages during the ramping up of a magnetic field intensity. When spectroscopic measurements at various intermediate flux densities are performed, i.e. when spectroscopic measurements are performed at various stages of a process of ramping up the magnetic field, a time resolved process may be measured indicating how magnetic properties at an area to be measured evolve during ramping up (or down) a magnetic field. In other words, for example when analyzing magnetic properties of a magnetic disc read/write head, the surface of the head may be mapped time-resolved in transitioning states at various differing magnetic flux densities during magnetic field generation.

According to an alternative embodiment of the invention, the specific frequency range of the irradiated electromagnetic microwave radiation irradiated during ramped up magnetic field is within 1 to 100GHz, preferably between 5 and 50GHz, and is switched or shaped into pulses of a length between 1ns and 1ms, preferably between 10ns and 10µs - and produces an oscillating magnetic field between 10µT and 100mT, preferably between 100µT and 1mT. Such values have been shown to be suitable for highly sensitive spectroscopic magnetic field measurements.

It should be pointed out that possible features and advantages of embodiments of the invention are described herein in relation to various details of the proposed measuring method as well as of the proposed measuring device. A person skilled in the art will recognize that the various features may be combined, adapted or replaced in order to create further embodiments of the proposed method or device, within the scope of the appended claims, and to possibly obtain synergy effects.

### BRIEF DESCRIPTION OF THE DRAWINGS

Possible aspects, features and advantages of embodiments of the present invention are apparent from the following description of specific embodiments with reference to the enclosed drawings, wherein said description and drawings are not to be interpreted as restricting the invention, which is only limited by the appended claims.
- Fig. 1: shows a device for localized measuring of a strong magnetic field according to an embodiment of the present invention.
- Fig. 2: visualized process steps and physical parameters varied during such steps in a method for localized measuring of a strong magnetic field according to an embodiment of the present invention.

The drawings are merely schematic and are not true to scale.

### DESCRIPTION OF PREFERRED EMBODIMENTS OF THE INVENTION

According to embodiments of the present invention, an alternative to magnetic force microscopy is proposed for measuring strong magnetic fields on a nanoscale. Therein, a magnetic-field-dependent photoluminescent (MFDP) particle is used as an atomic sized magnetic field sensor. Such sensor may be used, inter alia, for measuring strong magnetic fields exceeding 10mT generated e.g. on a surface area of a magnetic hard disc write/read head, i.e. a device which is specifically adapted to generating strong magnetic fields along small surface areas of only a few tens of nm² and at high magnetic field ramping velocities of up to 1 Tins (one Tesla per nanosecond) in order to enable writing and/or reading of single bits on a magnetic disc.

As an example for an MFDP particle, a nitrogen-vacancy (NV) center may be used and will be described in further detail below. However, other MFDP particles having similar properties to the described NV center may be used alternatively.

General features of the NV center and basic principles of applications using such NV centers are described, inter alia, in an overview article of L. Rondin et al.: "Magnetometry with nitrogen-vacancy defects in diamonds", Rep. Prog. Phys. 77 056503 (2014) (also published as arXiv:1311.5214; http://arxiv.org/abs/1311.5214) and in an overview article of M.W. Doherty et al: "The nitrogen-vacancy colour centre in diamond", Physics Reports 528, 1 (2013) (also published at http://arxiv.org/abs/1302.3288). Further information may be derived from P. Maletinsky et al.: "A robust scanning diamond sensor for nanoscale imaging with single nitrogen-vacancy centres", nature nanotechnology, vol. 7, May 2012, p. 320 ff and from J.-P. Tetienne et al.: "Nanoscale imaging and control of domain-wall hopping with a nitrogen-vacancy center microscope", Science , vol. 344, issue 6190, 20 June 2014, p. 1366 ff. Patents EP 2 163 392 B1 and US 7,752,899 B1 relate to applications of NV centers.

Briefly summarized, an NV center is a color center in diamond, which can be used as an atomic-sized magnetic field sensor by performing spectroscopy of its spin sublevels, followed by optical spin readout.

The NV center is a color center in diamond with a fluorescent optical transition in the red (637nm) and a spin triplet ground state comprising three states labeled by m S =-1,0,+1. As its most striking feature, the intensity of its fluorescence depends on the state of its ground state electron spin, i.e. it is brighter in state m S =0 than in states m S =+/-1, so that the center's spin state can be read out optically. Magnetic fields may be measured by microwave spectroscopy of the spin's Zeeman shift in a magnetic field. This scheme requires spin readout as a final step.

This feature enables one important application: The use of a single center as an atomic-size magnetic field sensor. Here, the magnetic field is measured by precision spectroscopy of a center's field-dependent Zeeman shift. This can be done, for instance, by excitation with an electromagnetic narrow-band microwave. Precisely, this scheme contains three steps: 1) The center is initialized in the bright m S =0 ground state by laser excitation. 2) The spin ground state is excited by a narrowband microwave, which switches the spin state into the dark m S =1 state if and only if the magnetic field has a particular value suitable to shift the 0->1 transition into resonance with the microwave frequency. 3) A successful spin excitation is detected by optical readout of the center's spin sublevels.

Unfortunately, this scheme does not operate at fields B > 10mT (= 100G), since spin readout of the NV center becomes impossible in this high-field regime. In these high fields, fluorescence does not depend on the spin state any more, owing to mixing of the spin sublevels.

Accordingly, a protocol is proposed herein that overcomes this problem. As its core tool, it employs a fast sweep of the magnetic field to perform spectroscopy, i.e. the actual magnetic field measurement, in a higher magnetic field than spin initialization and readout. In this way, spin preparation and readout is always performed in the low-field regime, while spectroscopy can be performed in an arbitrary high magnetic field, exceeding 10mT.

In other words, it is proposed to circumvent the above problem and to make the NV center usable for measurements of high magnetic fields. Here, both spin preparation and readout are performed in low field as before. In contrast, spectroscopy, i.e. the actual magnetic field measurement, is performed at high magnetic field, by ramping up the field to be measured between the preparation and the spectroscopy phase. The field to be measured is adiabatically ramped up before the spectroscopy phase and ramped back to a low value before optical spin readout. Spectroscopy itself can be performed at high magnetic fields, since it does not require optical excitation and is therefore insensitive to level mixing. After ramping down the field, the spectroscopy result is read out in a final step at low field. Overall, this enables measurement (spectroscopy) of high fields, while spin readout can be performed at low fields.

It may be noted that ramping of the field does not perturb the center's spin state as long as ramps are performed adiabatically, i.e. slow against e.g. an NV center's zero field splitting of 3GHz. This in practice requires a field sweep to 1T to be performed on a slower timescale than 3ns, i.e. a ramping up and down of the magnetic flux density with a rate of less than approx. 0,3T/ns, which should be of no concern for applications.

In particular, the scheme is suitable for imaging the magnetic field of hard disk write heads. These devices produce a strong (T) field, which can be ramped up and down reliably on a ns timescale. Employing this protocol in a scanning-probe magnetometer should therefore allow for imaging of write heads' magnetic field with simultaneously sub-nm resolution, nanoTesla sensitivity, nanosecond time resolution and Tesla dynamic range.

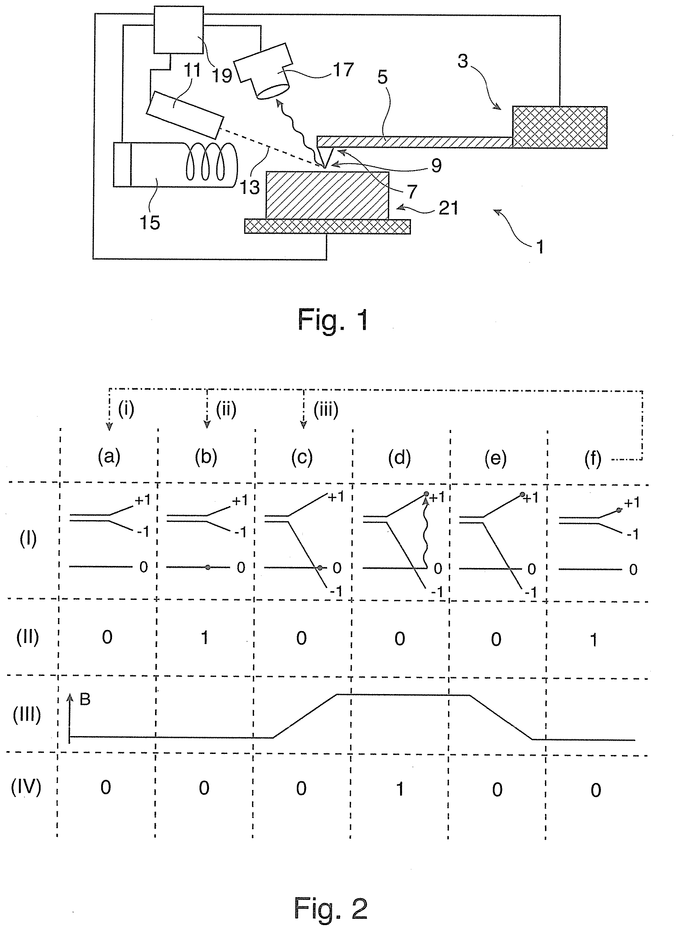

Features of a device 1 for measuring of a strong magnetic field on a nanoscale according to an embodiment of the present invention are now described with reference to Fig. 1.

The device 1 comprises a positioning element 3. The positioning element 3 is configured similarly as an atomic force microscope. A cantilever 5 may be positioned with a precision in a nanometer range using e.g. piezo elements. At an end of the cantilever 5, a carrier support 7 is provided. At a tip of this carrier support 7, a small diamond crystal may be held. The diamond crystal may have a size of a few tens of nanometers and may be precisely positioned by the positioning element 3. Accordingly, the diamond crystal may be precisely scanned along an area of a surface to be measured. Alternatively, in principle, the surface to be measured may be displaced relative to the diamond crystal being kept stationary.

Incorporated into the diamond crystal is a single or plural MFDP particles 9 in the form of NV centers. Thus, using the positioning element 3, the MFDP particle 9 may be positioned on a nanometer scale.

Furthermore, the device 1 comprises a light source 11 such as a laser for illuminating the MFDP particle 9. The laser may be a Nd:YAG laser emitting at a frequency of e.g. 532nm with a power of e.g.1mW, potentially chopped to pulses of 10ns-2µs length.. The laser is arranged and oriented such that emitted laser light 13 is directed onto the MFDP particle 9.

The device 1 further comprises an electromagnetic microwave generator 15. The microwave generator 15 is adapted and arranged for irradiating the MFDP particle 9 with electromagnetic microwave radiation in a frequency range of 1 - 100 GHz that can be switched or shaped into pulses with a length in the 1ns-1ms range.

Additionally, the device 1 comprises a photodetector 17 which is sufficiently sensitive to detect photoluminescence from the MFDP particle 9.

Finally, the device 1 comprises a controller 19. This controller 19 is adapted for controlling various components including the positioning device 3, the light source 11 and the microwave generator 15. Furthermore, the controller 19 comprises an interface with which it can control an external magnetic field generator 21 for generating the strong magnetic field to be measured. Such external magnetic field generator 21 may be e.g. a magnetic disc write/read head.

Using the controller 19, the components of the device 1 and the external magnetic field generator 21 may be controlled in accordance with an exemplary protocol for embodying a method according to the present invention. The protocol will now be described with reference to fig. 2.

Fig. 2 includes columns representing various method steps (a) to (f) generally corresponding to the method steps described above with respect to the first aspect of the invention. Lines (I) to (IV) visualize some physical properties or parameters during these method steps.

Line (I) visualizes a triplet of excitation levels m S = 0, -1 and +1 of an NV center. Particularly, Zeeman shifts of such levels upon increased magnet fields are shown in columns (c) to (e).

Line (II) indicates an ON (= "1") or OFF (= "0") state of the laser 11 for illuminating the MFDP particle 9.

Line (III) visualized a magnetic flux density B generated by the external magnetic field generator 21. The magnetic flux density is varied between a low magnetic field at e.g. significantly less than 10mT and a high magnetic field at e.g. significantly more than 100mT.

Finally, line (IV) indicates an ON (= "1") or OFF (= "0") state of the microwave generator 15.

The protocol visualized in fig. 2 comprises the following steps:
In step (a), the MFDP particle 9 is positioned at a desired location in close proximity to an area to be measured at the surface of the external magnetic field generator 21. For that purpose, the control 19 controls the positioning element 3 for displacing the cantilever 5 such that the MFDP particle 9 attached at the carrier support 7 is precisely positioned at the desired location.

In step (b), manipulations are performed for bringing the MFDP particle 9 into a predetermined excitation level. Specifically, an NV center is irradiated by the laser 11 with laser light 13 of a frequency of 532nm. Thereby, the NV center may be set to its spin ground state by optical pumping such that the NV center is in a defined spin level before continuing with the protocol. Optionally, the NV center may be transferred from its ground level m S = 0 to one of the other triplet spin levels by magnetic microwave irradiation such that the predetermined excitation level is not m S = 0 but one of m S = 1 or m S = -1.

Subsequently, in step (c), a magnetic flux density at the area to be measured is ramped up to more than 10mT. For this purpose, the controller 19 controls the external magnetic field generator 21, i.e. for example a hard disc write/read head, to increase its magnetic field in a restricted area to be measured. The external magnetic field generator 21 may be e.g. controlled to ramp up to a maximum magnetic flux density, i.e. to completely ramp up.

Alternatively, it may be controlled to ramp up to an intermediate magnetic flux density lower than the maximum magnetic flux density, i.e. subsequent method steps may be interpreted to be performed during ramping up the B field. In this case, the subsequent method steps may be repeated at particular instants during the ramp-up phase thereby allowing to obtain a time-dependent analysis of the process of ramping up the magnetic flux density (see branch (iii) in fig.2).

Then, in step (d), the MFDP particle 9 is irradiated by the electromagnetic wave generator 15 with electromagnetic microwave radiation in a specific frequency range. Depending on the irradiated frequency range, resonant absorption or stimulated emission may or may not occur in the NV center thereby changing its excitation state from the starting state initially prepared in step (b), e.g. the state m S = 0, to one of the other triplet states, e.g. m S =+/-1.

After such spectroscopy, in step (e), the magnetic flux density at the area to be measured is again ramped down to less than 10mT. Like the process of ramping up, also this ramping down is performed adiabatically, i.e. on a time scale slower than 3ns.

Finally, in step (f), an intensity of photoluminescence emitted by the MFDP particle 9 is measured using the photodetector 17. For this purpose, the MFDP particle 9 is again irradiated with the light source 11. Depending on whether or not resonant microwave absorption or stimulated emission has been induced during spectroscopy in step (d), photoluminescence properties of the MFDP particle 9 are modified. Accordingly, spectroscopy results may be read out optically by measuring the MFDP particle's photoluminescence.

Steps (b) to (f) or (c) to (f) may be repeated with different frequencies of electromagnetic microwaves for performing a full spectroscopy analysis (see branches (ii) or (iii) in fig. 2).

Steps (a) to (f) may be repeated at different locations along an area to be measured in order to obtain a space-resolved map of magnetic flux density properties along this area (see branch (i) in fig. 2). If the frequency of the electromagnetic microwaves used for spectroscopy in step (d) is kept constant, an "iso-flux-density-map" may be acquired. Alternatively, spectroscopy may be performed at various frequencies of the electromagnetic microwaves thereby enabling magnetic flux resolved imaging similar to the approach described by T. Haeberle et al.: "High-Dynamic-Range Imaging of Nanoscale Magnetic Fields Using Optimal Control of a Single Qubit", Physical Review Letter, 111, 170801 (2013).

Overall, embodiments of the method and device proposed herein allow for multiple advantages such as:
- high spatial resolution which is only limited by the size of the MFDP particle which in case of an NV center is atomically small, i.e. on the sub-nm scale;
- quantitative measurements are enabled as, in principle, all three vector components of a magnetic field may be quantitatively measured;
- measurements may be performed without negatively altering the sensor with the field to be measured as e.g. the magnet field of an NV center is five orders of magnitude weaker than a magnetic field of a hard disc write/read head;
- time-resolved measurements are enabled using suitable spectroscopy protocols. For example, a kind of slow motion imaging may be performed for visualizing time-dependent changes of the magnetic field in a nanosecond range;

Finally, it should be pointed out that the terms "comprise", "have", etc. should not rule out the presence of further additional elements. Term such as "a" or "one" do not exclude the presence of a plurality of elements or subject matters. The reference numbers in the claims solely serve the purpose of better readability and should not restrict the scope of protection of the claims in any manner.

### LIST OF REFERENCE SIGNS

- 1: device for measuring strong magnetic fields
- 3: positioning element
- 5: cantilever
- 7: carrier support
- 9: MFDP particle
- 11: light source
- 13: light
- 15: electromagnetic microwave generator
- 17: photodetector
- 19: controller
- 21: external magnetic field generator

## Claims

1. Method for measuring a magnetic flux density (B) of strong magnetic fields at an area to be measured on a nanoscale by detecting a quantum state of a magnetic-field-dependent photoluminescent particle, the method comprising:
(a) positioning the magnetic-field-dependent photoluminescent particle (9) in close proximity to the area to be measured;
(b) performing manipulations for bringing the magnetic-field-dependent photoluminescent particle (9) into a predetermined excitation level;
(c) ramping up the magnetic flux density (B) at the area to be measured;
(d) irradiating the magnetic-field-dependent photoluminescent particle (9) with electromagnetic microwave radiation in a specific frequency range;
(e) ramping down the magnetic flux density at the area to be measured;
(f) detecting the quantum state of the magnetic-field-dependent photoluminescent particle,
wherein steps (c) to (f) are performed in the indicated order and steps (a) and (b) are performed before step (c), and
wherein, in step (f), the detected quantum state is the detected quantum state as induced during step (d).

2. Method according to claim 1, wherein the magnetic-field-dependent photoluminescent particle (9) is an NV center in a diamond crystal.

3. Method according to claim 1 or 2, wherein in step (c) the magnetic flux density at the area to be measured is ramped up to magnetic flux densities exceeding 10mT.

4. Method according to one of the preceding claims, wherein in step (b) the magnetic-field-dependent photoluminescent particle (9) is brought into the predetermined excitation level using illumination with light (13).

5. Method according to one of the preceding claims, wherein the quantum state of the magnetic-field-dependent photoluminescent particle is detected by measuring an intensity of photoluminescence of the magnetic-field-dependent photoluminescent particle.

6. Method according to one of the preceding claims, wherein in steps (c) and (e) the ramping up and down of the magnetic flux density is performed adiabatically.

7. Method according to one of the preceding claims, wherein in steps (c) and (e) the ramping up and down of the magnetic flux density is performed on a time scale of more than 1ns.

8. Method according to one of the preceding claims, further comprising repositioning the magnetic-field-dependent photoluminescent particle (9) along the area to be measured thereby scanning the area to be measured and repeating the steps (b) to (f) at each position.

9. Method according to one of the preceding claims, wherein step (d) is performed after completely ramping up of the magnetic flux density.

10. Method according to one of claims 1 to 8, wherein step (d) is performed during the ramping up of the magnetic flux density.

11. Method according to claim 10, wherein steps (b) to (f) are repeated several times and wherein step (d) is performed at different stages during the ramping up of the magnetic flux density.

12. Method according to one of the preceding claims, wherein the specific frequency range of the irradiated electromagnetic microwave radiation is within 1 to 100GHz, preferably between 5 and 50GHz, and is switched or shaped into pulses of a length between 1ns and 1ms, preferably between 10ns and 10µs, and produces an oscillating magnetic field between 10µT and 100mT, preferably between 100µT and 1mT.

13. Method according to one of claims 1 to 12, wherein only the step of irradiating with electromagnetic microwave radiation is performed at the ramped-up magnetic flux density whereas the step of detecting the quantum state of the of the magnetic-field-dependent photoluminescent particle is always performed after ramping down the magnetic flux density.

14. Method of analyzing magnetic field generation properties of a hard disk write/read head using the method according to one of claims 1 to 13.

15. Device (1) for localized measuring of a strong magnetic field on a nanoscale, the device comprising:
a positioning element (3) for positioning a particle relative to the magnetic field to be measured;
a magnetic-field-dependent photoluminescent particle (9) which is provided at the positioning element (3);
a light source (11) for illuminating the magnetic-field-dependent photoluminescent particle (9);
a microwave generator (15) for irradiating the magnetic-field-dependent photoluminescent particle (9) with electromagnetic microwave radiation;
a photodetector (17) for detecting photoluminescence from the magnetic-field-dependent photoluminescent particle (9);
a controller (19);
wherein the controller (19) is adapted to controlling in accordance with a method according to one of claims 1 to 13 the positioning element (3), the light source (11),
the microwave generator (15) and an external magnetic field generator (21), such as a hard disk write/read head, for generating the strong magnetic field to be measured.

## Patentansprüche

1. Verfahren zum Messen einer magnetischen Flussdichte (B) starker Magnetfelder an einem zu messenden Bereich auf einer Nanoskala durch Erfassen eines Quantenzustands eines magnetfeldabhängigen photolumineszenten Partikels; wobei das Verfahren umfasst:
(a) Positionieren des magnetfeldabhängigen photolumineszenten Partikels (9) in enger Nähe zu dem zu messenden Bereich;
(b) Durchführen von Manipulationen, um den magnetfeldabhängigen photolumineszenten Partikel (9) in ein vorbestimmtes Anregungsniveau zu bringen;
(c) Hochfahren der magnetischen Flussdichte (B) an dem zu messenden Bereich;
(d) Bestrahlen des magnetfeldabhängigen photolumineszenten Partikels (9) mit elektromagnetischer Mikrowellenstrahlung in einem spezifischen Frequenzbereich;
(e) Herunterfahren der magnetischen Flussdichte in dem zu messenden Bereich;
(f) Erfassen des Quantenzustands des magnetfeldabhängigen photolumineszenten Partikels,
wobei die Schritte (c) bis (f) in der angegebenen Reihenfolge durchgeführt werden und die Schritte (a) und (b) vor Schritt (c) durchgeführt werden, und
wobei in Schritt (f) der erfasste Quantenzustand der erfasste Quantenzustand ist, wie er in Schritt (d) induziert wurde.

2. Verfahren nach Anspruch 1, wobei der magnetfeldabhängige photolumineszente Partikel (9) ein NV-Zentrum in einem Diamantkristall ist.

3. Verfahren nach Anspruch 1 oder 2, wobei in Schritt (c) die magnetische Flussdichte an dem zu messenden Bereich auf magnetische Flussdichten von über 10mT hochgefahren wird.

4. Verfahren nach einem der vorhergehenden Ansprüche, wobei in Schritt (b) der magnetfeldabhängige photolumineszente Partikel (9) durch Bestrahlung mit Licht (13) in das vorbestimmte Anregungsniveau gebracht wird.

5. Verfahren nach einem der vorhergehenden Ansprüche, wobei der Quantenzustand des magnetfeldabhängigen photolumineszenten Partikels durch Messen einer Photolumineszenz-Intensität des magnetfeldabhängigen photolumineszenten Partikels erfasst wird.

6. Verfahren nach einem der vorhergehenden Ansprüche, wobei in den Schritten (c) und (e) das Hoch- und Herunterfahren der magnetischen Flussdichte adiabatisch durchgeführt wird.

7. Verfahren nach einem der vorhergehenden Ansprüche, wobei in den Schritten (c) und (e) das Hoch- und Herunterfahren der magnetischen Flussdichte auf einer Zeitskala von mehr als 1ns durchgeführt wird.

8. Verfahren nach einem der vorhergehenden Ansprüche, weiter umfassend ein Repositionieren des magnetfeldabhängigen photolumineszenten Partikels (9) entlang des zu messenden Bereichs, wodurch der zu messende Bereich abgetastet wird, und ein Wiederholen der Schritte (b) bis (f) an jeder Position.

9. Verfahren nach einem der vorhergehenden Ansprüche, wobei Schritt (d) nach einem vollständigen Hochfahren der magnetischen Flussdichte durchgeführt wird.

10. Verfahren nach einem der Ansprüche 1 bis 8, wobei Schritt (d) während des Hochfahrens der magnetischen Flussdichte durchgeführt wird.

11. Verfahren nach Anspruch 10, wobei die Schritte (b) bis (f) mehrmals wiederholt werden, und wobei Schritt (d) in verschiedenen Stadien während des Hochfahrens der magnetischen Flussdichte durchgeführt wird.

12. Verfahren nach einem der vorhergehenden Ansprüche, wobei der spezifische Frequenzbereich der eingestrahlten elektromagnetischen Mikrowellenstrahlung innerhalb von 1 bis 100GHZ, vorzugsweise zwischen 5 und 50GHZ, liegt, und in Pulse einer Länge zwischen 1ns und 1ms, vorzugsweise zwischen 10ns und 10ps, geschaltet oder geformt wird, und ein oszillierendes Magnetfeld zwischen 10µT und 100mT, vorzugsweise zwischen 100µT und 1mT, erzeugt.

13. Verfahren nach einem der Ansprüche 1 bis 12, wobei nur der Schritt des Bestrahlens mit elektromagnetischer Mikrowellenstrahlung bei der hochgefahrenen magnetischen Flussdichte durchgeführt wird, wohingegen der Schritt des Erfassens des Quantenzustands des magnetfeldabhängigen photolumineszenten Partikels immer nach dem Herunterfahren der magnetischen Flussdichte durchgeführt wird.

14. Verfahren zum Analysieren von
Magnetfelderzeugungseigenschaften eines Festplatten-Schreib-/Lesekopfes unter Verwendung des Verfahrens nach einem der Ansprüche 1 bis 13.

15. Vorrichtung (1) zum lokalisierten Messen eines starken Magnetfeldes auf einer Nanoskala, wobei die Vorrichtung umfasst:
ein Positionierungselement (3) zum Positionieren eines Partikels relativ zu dem zu messenden Magnetfeld;
einen magnetfeldabhängigen photolumineszenten Partikel (9), der an dem Positionierungselement (3) bereitgestellt ist;
eine Lichtquelle (11) zum Bestrahlen des magnetfeldabhängigen photolumineszenten Partikels (9);
einen Mikrowellengenerator (15) zur Bestrahlen des magnetfeldabhängigen photolumineszenten Partikels (9) mit elektromagnetischer Mikrowellenstrahlung;
einen Photodetektor (17) zum Erfassen einer Photolumineszenz von dem magnetfeldabhängigen photolumineszenten Partikel (9);
ein Steuergerät (19);
wobei das Steuergerät (19) dazu angepasst ist, gemäß einem Verfahren nach einem der Ansprüche 1 bis 13 das Positionierungselement (3), die Lichtquelle (11), den Mikrowellengenerator (15) und einen externen Magnetfeldgenerator (21), wie z. B. einen Festplatten-Schreib-/Lesekopf, zum Generieren des zu messenden starken Magnetfelds zu steuern.

## Revendications

1. Procédé pour mesurer une densité de flux magnétique (B) de champs magnétiques forts dans une zone à mesurer à l'échelle nanométrique par détection d'un état quantique d'une particule photoluminescente dépendant du champ magnétique, le procédé comprenant:
(a) positionner la particule photoluminescente dépendant du champ magnétique (9) à proximité étroite de la zone à mesurer ;
(b) effectuer des manipulations pour amener la particule photoluminescente dépendant du champ magnétique (9) à un niveau d'excitation prédéterminé ;
(c) augmenter la densité de flux magnétique (B) dans la zone à mesurer ;
(d) irradier la particule photoluminescente dépendant du champ magnétique (9) avec un rayonnement électromagnétique micro-ondes dans une gamme de fréquences spécifique ;
(e) diminuer la densité de flux magnétique dans la zone à mesurer ;
(f) détecter l'état quantique de la particule photoluminescente dépendant du champ magnétique,
dans lequel les étapes (c) à (f) sont effectuées dans l'ordre indiqué et les étapes (a) et (b) sont effectuées avant l'étape (c), et
dans lequel, à l'étape (f), l'état quantique détecté est l'état quantique détecté tel qu'il a été induit à l'étape (d) .

2. Procédé selon la revendication 1, dans lequel la particule photoluminescente dépendant du champ magnétique (9) est un centre NV dans un cristal de diamant.

3. Procédé selon la revendication 1 ou 2, dans lequel, à l'étape (c), la densité de flux magnétique dans la zone à mesurer est augmentée jusqu'à des densités de flux magnétique supérieures à 10 mT.

4. Procédé selon l'une des revendications précédentes, dans lequel, à l'étape (b), la particule photoluminescente dépendant du champ magnétique (9) est amenée au niveau d'excitation prédéterminé par illumination avec de la lumière (13).

5. Procédé selon l'une des revendications précédentes, dans lequel l'état quantique de la particule photoluminescente dépendant du champ magnétique est détecté en mesurant l'intensité de la photoluminescence de la particule photoluminescente dépendant du champ magnétique.

6. Procédé selon l'une des revendications précédentes, dans lequel, aux étapes (c) et (e), l'augmentation et la diminution de la densité de flux magnétique sont effectuées de manière adiabatique.

7. Procédé selon l'une des revendications précédentes, dans lequel, aux étapes (c) et (e), l'augmentation et la diminution de la densité de flux magnétique sont effectuées sur une échelle de temps supérieure à 1 ns.

8. Procédé selon l'une des revendications précédentes, comprenant en outre l'étape consistant à repositionner la particule photoluminescente dépendant du champ magnétique (9) le long de la zone à mesurer afin de balayer la zone à mesurer et de répéter les étapes (b) à (f) à chaque position.

9. Procédé selon l'une des revendications précédentes, dans lequel l'étape (d) est effectuée après une augmentation complète de la densité de flux magnétique.

10. Procédé selon l'une des revendications 1 à 8, dans lequel l'étape (d) est effectuée pendant l'augmentation de la densité de flux magnétique.

11. Procédé selon la revendication 10, dans lequel les étapes (b) à (f) sont répétées plusieurs fois et dans lequel l'étape (d) est effectuée à différents stades pendant l'augmentation de la densité de flux magnétique.

12. Procédé selon l'une des revendications précédentes, dans lequel la gamme de fréquences spécifiques du rayonnement électromagnétique micro-ondes irradié est comprise entre 1 et 100 GHz, de préférence entre 5 et 50 GHz, et est commutée ou formée en impulsions d'une longueur comprise entre 1 ns et 1 ms, de préférence entre 10 ns et 10 ps, et produit un champ magnétique oscillant compris entre 10 µT et 100 mT, de préférence entre 100 µT et 1 mT.

13. Procédé selon l'une des revendications 1 à 12, dans lequel seule l'étape consistant à irradier avec un rayonnement électromagnétique micro-ondes est effectuée à la densité de flux magnétique augmentée, tandis que l'étape consistant à détecter l'état quantique de la particule photoluminescente dépendant du champ magnétique est toujours effectuée après la diminution de la densité de flux magnétique.

14. Procédé pour analyser les propriétés de génération de champ magnétique d'une tête d'écriture/lecture de disque dur en utilisant le procédé selon l'une des revendications 1 à 13.

15. Dispositif (1) pour mesurer de manière localisée un champ magnétique fort à l'échelle nanométrique, le dispositif comprenant :
un élément de positionnement (3) pour positionner une particule par rapport au champ magnétique à mesurer ;
une particule photoluminescente dépendant du champ magnétique (9) qui est placée à l'élément de positionnement (3) ;
une source de lumière (11) pour illuminer la particule photoluminescente dépendant du champ magnétique (9) ;
un générateur de micro-ondes (15) pour irradier la particule photoluminescente dépendant du champ magnétique (9) avec un rayonnement électromagnétique micro-ondes ;
un photodétecteur (17) pour détecter la photoluminescence de la particule photoluminescente dépendant du champ magnétique (9) ;
un dispositif de commande (19) ;
dans lequel le dispositif de commande (19) est adapté à commander, conformément à un procédé selon l'une des revendications 1 à 13, l'élément de positionnement (3), la source de lumière (11), le générateur de micro-ondes (15) et un générateur de champ magnétique externe (21), tel qu'une tête d'écriture/lecture de disque dur, pour générer le champ magnétique fort à mesurer.
